# EUROPÄISCHE PATENTSCHRIFT

(11) **EP 3 134 748 B1**
(45) Veröffentlichungstag und Bekanntmachung des Hinweises auf die Patenterteilung: **20.10.2021**
(21) Anmeldenummer: 15717086.1
(22) Anmeldetag: 02.04.2015
(51) Int. Cl.: H01P 1/26, H01P 5/107, G01S 7/03, G01S 13/931

(54) **RADARSYSTEM ZUR UMFELDERFASSUNG FÜR EIN FAHRZEUG SOWIE PLATINE FÜR EIN SOLCHES RADARSYSTEM**
RADAR SYSTEM FOR DETECTING SOURROUNDINGS OF A VEHICLE AND PRINTED CIRCUIT BOARD FOR SAID RADAR SYSTEM
SYSTÈME DE RADAR POUR DÉTECTER LES ENVIRONS D'UN VÉHICULE ET CIRCUIT IMPRIMÉ POUR UN TEL SYSTÈME DE RADAR

(30) Priorität: 22.04.2014 DE 102014207571
(43) Veröffentlichungstag der Anmeldung: 01.03.2017
(73) Patentinhaber: Conti Temic microelectronic GmbH, 90411 Nürnberg (DE)
(72) Erfinder: MENGE, Michael, 81475 München (DE)
(74) Vertreter: Continental Corporation
(86) Internationale Anmeldenummer: PCT/DE2015/200246
(87) Internationale Veröffentlichungsnummer: WO 2015/161849

(56) Entgegenhaltungen:
- EP-A1- 0 642 190
- EP-A2- 2 595 187
- WO-A1-2008/146535
- US-A1- 2009 224 857
- US-A1- 2009 251 357
- US-A1- 2010 134 376
- US-A1- 2010 225 539
- US-B1- 7 639 173

## Beschreibung

Die Erfindung betrifft ein Radarsystem zur Umfelderfassung für ein Fahrzeug sowie Platine für ein solches Radarsystem.

Radarsysteme finden sich beispielsweise in sowohl geführten als auch autonomen Fahrzeugen, Baumaschinen oder Fertigungsanlagen. Insbesondere in von einem Fahrer geführten Fahrzeug ermitteln Radarsysteme Werte bestimmter Umgebungsparameter, beispielsweise einer Entfernung des Fahrzeuges zu einem anderen Objekt, wodurch beispielsweise die Entscheidungsfindung des Fahrers unterstützt oder auf Sicherheitsrisiken hingewiesen werden kann. Insbesondere Radarsysteme zur Abstandsmessung finden immer häufiger Verwendung, beispielsweise als Einparkhilfe oder Kollisionswarnsysteme in Fahrzeugen.

Solche Radarsysteme werden insbesondere im Hochfrequenzbereich betrieben, auch HF-Bereich genannt. Dieser umfasst beispielsweise einen Frequenzbereich von 10 GHz bis 100 GHz. Weiterhin weisen solche Radarsysteme üblicherweise eine HF-Elektronik mit entsprechenden HF-Bauteilen auf, beispielsweise HF-Sender und -Empfänger sowie geeignete Antennen. Diese sind auf einer Platine angeordnet und geeignet miteinander verbunden. Die Platine umfasst dabei eine Substratschicht, auf der zur Übertragung eines insbesondere hochfrequenten Signals eine Leitung aus einem elektrisch leitenden Material aufgebracht. Die Substratschicht ist dabei typischerweise aus einem dielektrischen Material gefertigt, das durch einen möglichst geringen Verlustfaktor charakterisiert ist, um das Signal möglichst verlustfrei zu übertragen. Der Verlustfaktor ist hierbei ein Maß für das Verhältnis von Wirkwiderstand und Blindwiderstand des Materials und häufig als sogenannter Verlustwinkel oder als Tangens dieses Verlustwinkels angegeben. Desweiteren ist typischerweise wenigstens ein Wellenabschluss (auch Abschlusswiderstand oder Wellensumpf genannt) vorgesehen, beispielsweise zur Impedanzanpassung eines Signalanschlusses des Radarsystems. Dazu ist der Wellenabschluss an ein Leitungsende einer Signalleitung angeschlossen. Eine Anforderung an einen Wellenabschluss ist dabei, dass dieser möglichst reflexionsarm, das heißt insbesondere möglichst verlustreich ist. Mit anderen Worten: ein mittels der Signalleitung eingehendes Signal wird möglichst gut absorbiert und insbesondere nicht oder lediglich wenig reflektiert.

Dazu ist es beispielsweise möglich, am Leitungsende eine sogenannte Absorbermatte anzuordnen, die aus einem verlustreichen Material gefertigt ist. Diese wird beispielsweise als zusätzliche Schicht auf die Substratschicht derart aufgeklebt, dass das Leitungsende von der Absorbermatte eingefasst ist. Beispielsweise ist aus der JPH09139608 bekannt, zum Abschließen eines streifenförmigen Leiters diesen endseitig mit einem U-förmigen Dünnschichtwiderstand einzufassen. Das verwendete verlustreiche Material ist typischerweise teuer. Desweiteren stellt das Aufbringen der Absorbermatte einen zusätzlichen Prozessschritt in der Fertigung der Platine dar. Weiterhin wird auf der Substratschicht ausreichend Platz zur Unterbringung der Absorbermatte benötigt, wodurch die Platine entsprechend groß ausgelegt sein muss.

Alternativ ist es möglich, einen als separates Bauteil, beispielsweise in SMD-Ausführung ausgebildeten Wellenabschluss aufzulöten und mit dem Leitungsende zu verbinden. Solche Bauteile sind jedoch lediglich für einen eingeschränkten Frequenzbereich und insbesondere für bezüglich Radarsystemen zu geringe Frequenzen verfügbar. Desweiteren sind solche Bauteile typischerweise teuer.

Eine weitere Alternative ist eine Verwendung einer Antenne als Wellenabschluss. Das in einen solchen Wellenabschluss eingehende Signal wird dann abgestrahlt. Insbesondere bei Radarsystemen sind jedoch häufig weitere Antennen vorgesehen sind, deren Funktionalität durch einen als Antenne ausgebildeten Wellenabschluss nachteilig beeinflusst wird; zumal diese typischerweise Signale der gleichen Frequenz übertragen und/oder empfangen. Ein derartiger Wellenabschluss ist folglich für Radarsysteme ungeeignet.

Die US 2009/0224857 A1 offenbart eine Wellenleiterplatte zwischen zwei Substraten mit gleichem Verlustfaktor, die harmonische Schwingungen zwischen den beiden Substraten unterdrückt, damit keine elektrische Energie unkontrolliert zurücktransportiert wird.

Dokument WO2008146535 A1 befasst sich mit einem Wellenabschluß, um effektiv Reflektionen zu unterdrücken.

Die EP 0 642 190 A1 offenbart einen Patch als Wellenabschluss, der als eine Art Absorbermatte auf dem Substrat aufgetragen ist, um den Energietransfer in eine Mikrostreifenleitung zu maximieren.

Die EP 2 595 187 A2 zeigt einen Transitionsblock mit zwei Substraten. Der Transitionsblock stellt das Überleiten einer Hohlleiterwelle in eine leitergeführte Welle sicher.

Aus der US 201 0/134376 A1 ist eine elektrische Verbindung zwischen einer HF-Schaltung und einer Radarantenne bekannt, bei der die elektrische Verbindung einen Übergang mit einem Antennensubstrat aufweist. Der elektrische Anschluss wird dabei verlustarm ausgestaltet, indem ein für Mikrowellen- oder Millimeterwellenanwendungen verlustarmes HF-Antennensubstrat verwendet wird. Als Antennensubstrat werden dabei verschiedene verlustarme Materialien vorgeschlagen, wie beispielsweise organisches Harz, Flüssigkristallpolymer oder anorganische Materialen, wie z. B. Halbleiter, Keramik, Glas oder Verbundwerkstoffe.

Eine Aufgabe der Erfindung ist es daher, ein verbessertes Radarsystem anzugeben. Dabei soll eine möglichst einfach und kostengünstig zu fertigende Platine für ein solches Radarsystem angegeben werden. Dazu soll insbesondere ein für ein Radarsystem geeigneter Wellenabschluss angegeben werden.

Diese Aufgabe wird erfindungsgemäß gelöst durch ein Radarsystem mit den Merkmalen des Anspruchs 1 und eine Platine mit den Merkmalen des Anspruchs 15. Vorteilhafte Ausgestaltungen, Weiterbildungen und Varianten sind Gegenstand der Unteransprüche. Die im Hinblick auf das Radarsystem angeführten Vorteile und bevorzugten Ausführungsvarianten sind auch auf die Platine zu übertragen.

Hierzu ist vorgesehen, dass ein Radarsystem zur Umfelderfassung für ein Fahrzeug eine Platine aufweist, die insbesondere als Mehrlagenplatine ausgebildet ist. Unter einer Mehrlagenplatine wird insbesondere verstanden, dass die Platine mehrere aus einem elektrisch leitenden Material, vorzugsweise Kupfer gefertigte Lagen aufweist, die mittels einer Anzahl von Substratschichten in einer Stapelrichtung zu einem Stapel verbunden sind. Dabei sind die Substratschichten jeweils aus einem vorzugsweise dielektrischen Material gefertigt. Weiterhin ist vorgesehen, dass die Platine eine Signalleitung zur Übertragung eines hochfrequenten Signals aufweist. Des Weiteren umfasst die Platine einen Wellenabschluss mit einer Abschlussleitung, die mit der Signalleitung verbunden ist. Mit anderen Worten: der Wellenabschluss schließt die Signalleitung mittels der Abschlussleitung ab. Des Weiteren umfasst die Platine eine erste Substratschicht, die aus einem ersten Material mit einem ersten Verlustfaktor gefertigt ist sowie eine auf der ersten Substratschicht aufgebrachte erste Lage, welche die Signalleitung umfasst. Das heißt, die Signalleitung ist in der ersten Lage und auf der ersten Substratschicht angeordnet. Zusätzlich umfasst die Platine eine zweite Substratschicht, die aus einem zweiten Material mit einem zweiten Verlustfaktor gefertigt ist, der größer ist als der erste Verlustfaktor, um eine Abschwächung, Dämpfung oder Absorption des Signals zu erzielen, sowie eine auf der zweiten Substratschicht aufgebrachte zweite Lage, welche die Abschlussleitung umfasst. Das heißt, die Abschlussleitung ist in der zweiten Lage angeordnet. Die Abschlussleitung und die Signalleitung werden im Folgenden jeweils auch allgemein als Leitung bezeichnet.

Insbesondere ist die erste Lage nicht gleich der zweiten Lage, das heißt, die erste und die zweite Lage sind nicht beide zwischen der ersten und der zweiten Substratschicht angeordnet. Bevorzugterweise ist die erste Lage als sogenannte Top-Lage oder Außenlage ausgebildet, das heißt die erste Lage ist auf einer Oberseite der Platine angebracht. Dadurch ist es möglich, die Signalleitung vorteilhaft als Mikrostreifenleiter, sogenannter microstrip auszubilden. Eine solche Signalleitung ist insbesondere kostengünstig und einfach zu fertigen.

Ein insbesondere hochfrequentes Signal mit einem diesem zugeordneten elektromagnetischen Feld wird typischerweise nicht ausschließlich innerhalb der jeweiligen Leitung geführt, sondern das Feld wechselwirkt auch mit dem die Leitung umgebenden Material. Dadurch hat die Substratschicht, auf der die jeweilige Lage aufgebracht ist, abhängig von dem Material aus dem diese Substratschicht gefertigt ist einen entsprechenden Einfluss auf das geführte Signal.

Eine Abschwächung, Dämpfung oder Absorption des Signals wird in dem Wellenabschluss insbesondere dadurch erzielt, dass dieser das Signal von der vergleichsweise verlustarmen ersten Lage in die vergleichsweise verlustreiche zweite Lage führt oder leitet. Unter verlustarm und verlustreich wird hierbei verstanden, dass die jeweilige Lage auf einer Substratschicht aufgebracht ist, die aus einem verlustarmen beziehungsweise verlustreichen Material gefertigt ist. Die Abschwächung ist insbesondere durch den Verlustfaktor quantifiziert, der insbesondere den sogenannten Verlustwinkel des jeweiligen Materials bezeichnet oder auch den Tangens dieses Verlustwinkels, sogenannter loss tangent. Je geringer der Verlustfaktor des Materials einer bestimmten Substratschicht, desto verlustärmer ist die Führung des Signals mittels einer auf dieser Substratschicht aufgebrachten Leitung. Insbesondere ist der Verlustfaktor frequenzabhängig. Mit verlustarm und verlustreich ist dann insbesondere gemeint, dass bei einer gegebenen Frequenz der Verlustfaktor des Materials der jeweiligen Substratschicht im Vergleich zu dem Verlustfaktor des Material einer anderen Substratschicht geringer beziehungsweise größer ist. Erfindungsgemäß führt der Wellenabschluss ein auf einer verlustarmen Lage geführtes Signal in eine verlustreiche Lage.

Eine Platine für eine Hochfrequenzanwendung, insbesondere für ein Radarsystem ist häufig als Mehrlagenplatine mit einer für ein hochfrequentes Signal verlustarmen Substratschicht und wenigstens einer verlustreichen, dafür typischerweise günstigeren Substratschicht ausgebildet. Für die verlustarme Schicht wird dabei beispielsweise das unter dem Markennamen RO3003 erhältliche Material und für die verlustreiche Schicht ein faserverstärktes Epoxidharz verwendet, wie es unter der Materialkennung FR4 bekannt ist. Die verlustreiche, günstigere Substratschicht dient üblicherweise zur Aufnahme weiterer nicht-HF-Elektronikkomponenten. Dabei ist ein besonders einfacher und kostengünstiger Wellenabschluss insbesondere dadurch realisierbar, dass keine zusätzlichen Komponenten oder Absorberschichten (beispielsweise Absorbermatten) zur Ausbildung des Wellenabschlusses notwendig sind. Der Wellenabschluss ist vorteilhaft lediglich aus den bereits ohnehin zur Ausbildung der Platine vorgesehenen Substratschichten und Lagen hergestellt. Ein solcher Wellenabschluss ist zudem vorteilhafterweise reflexionsarm, das heißt ein möglichst großer Anteil, insbesondere mehr als 90% des in den Wellenabschluss eingehenden Signals wird von diesem aufgenommen.

In einer geeigneten Weiterbildung sind die Abschlussleitung und die Signalleitung mittels eines Hohlleiters verbunden, wodurch insbesondere eine geeignete Verbindung zwischen den beiden Lagen bereitgestellt ist. Da die beiden Lagen vorzugsweise unterschiedlich verlustreich für das insbesondere hochfrequente Signal sein sollen, sind die beiden Lagen durch wenigstens eine Substratschicht und möglicherweise weitere Lagen getrennt voneinander angeordnet. Mittels des Hohlleiters ist es dann insbesondere möglich, das Signal von der ersten Lage durch diese Substratschicht und eventuell weitere Substratschichten und/oder Lagen hindurch und schließlich in die zweite Lage zu führen.

Der Hohlleiter ist dabei insbesondere als sogenannter SIW (substrate integrated waveguide) ausgebildet. Das heißt, der Hohlleiter weist einen Hohlleiterraum auf, der in einer der Substratschichten liegt. Insbesondere ist der Hohlleiterraum daher mit dem entsprechenden Material gefüllt. Der Hohlleiter umfasst eine Anzahl von vertikalen und horizontalen Hohlleiterwänden, die den Hohlleiterraum begrenzen. Die horizontalen Hohlleiterwände sind dabei jeweils innerhalb einer der Lagen ausgebildet; die vertikalen Hohlleiterwände erstrecken sich im Wesentlichen senkrecht dazu, das heißt insbesondere in Stapelrichtung. Dabei verlaufen die Hohlleiterwände jeweils wenigstens teilweise durch eine oder mehrere der Substratschichten. Zweckmäßigerweise sind die Hohlleiterwände aus einem leitenden Material gefertigt, insbesondere aus dem gleichen Material wie die Lagen.

Zur Übertragung des Signals von der Signalleitung in den Hohlleiter und vom Hohlleiter in die Abschlussleitung sind geeignete Übergangsbereiche vorgesehen. Im Falle einer als Mikrostreifenleiter ausgebildeten Signalleitung ist beispielsweise ein in Richtung des Hohlleiters kontinuierlich breiter werdender Leiterstreifen (auch taper genannt) vorgesehen. Alternativ ist beispielsweise die Signalleitung selbst als Hohlleiter ausgebildet und direkt an den Hohlleiter des Wellenabschlusses angeschlossen.

Zweckmäßigerweise weist der Hohlleiter einen ersten Abschnitt auf, der in der ersten Substratschicht angeordnet ist und einen zweiten Abschnitt, der in der zweiten Substratschicht angeordnet ist. Dadurch ist es möglich, das Signal von der verlustarmen ersten Substratschicht in die verlustreiche zweite Substratschicht zu führen.

In einer geeigneten Ausgestaltung ist zwischen der ersten und der zweiten Substratschicht eine erste Masselage angeordnet. Diese ist dann insbesondere auch zwischen der ersten und der zweiten Lage angeordnet. Mit anderen Worten: die Masselage ist von zwei Substratschichten eingefasst, die wiederum durch die beiden Lagen eingefasst sind. Auf diese Weise ist insbesondere ein dreilagiger Aufbau realisiert. Die erste Masselage dient vorzugsweise als Masselage in Falle einer als Mikrostreifenleiter ausgebildeten Signalleitung. In diesem Fall ist die Signalleitung ein auf der ersten Substratschicht als Teil der ersten Lage aufgebrachter Streifen und die Masselage ist auf der diesem Streifen gegenüberliegenden Seite der ersten Substratschicht angeordnet.

Bevorzugt dient die Masselage als horizontale, das heißt sich senkrecht zur Stapelrichtung erstreckende Hohlleiterwand. Der erste Abschnitt des Hohlleiters ist dann durch einen Teil der ersten Masselage und einen Teil der ersten Lage begrenzt; der zweite Abschnitt durch einen weiteren Teil der ersten Masselage und einen Teil der zweiten Lage. Bevorzugterweise dient der gleiche Teil der ersten Masselage als horizontale Hohlleiterwand beider Abschnitte.

Insbesondere ist in einer bevorzugten Weiterbildung in die erste Masselage eine Öffnung eingebracht, das heißt die Masselage ist nicht durchgängig ausgeführt, sondern weist einen ausgenommenen Bereich auf. Die Öffnung ist zweckmäßigerweise in dem Teil der ersten Masselage ausgeführt, der eine horizontale Wand des Hohlleiters darstellt. Dies ermöglicht eine besonders reflexionsarme oder sogar reflexionsfreie Weiterleitung des Signals vom ersten Abschnitt des Hohlleiters in dessen zweiten Abschnitt. Die Signalleitung und die Abschlussleitung sind dann insbesondere derart verbunden, dass das Signal von der ersten Lage durch die erste Substratschicht, durch die Öffnung, durch die zweite Substratschicht und schließlich in die zweite Lage führbar ist.

In einer bevorzugten Ausgestaltung ist die Öffnung als Kopplungsschlitz ausgeführt. Unter Kopplungsschlitz wird dabei eine Öffnung verstanden, die sich über eine bestimmte Schlitzbreite zwischen zwei gegenüberliegenden vertikalen Wänden erstreckt und senkrecht dazu und in der Ebene der ersten Masselage eine bestimmte Schlitzlänge aufweist. Dabei ist die Schlitzbreite vorzugsweise größer als die Schlitzlänge. Insbesondere sind die Schlitzbreite und/oder die Schlitzlänge in Abhängigkeit der Frequenz des Signals ausgewählt. Vorzugsweise entspricht die Schlitzbreite im Wesentlichen einem Abstand zwischen zwei gegenüberliegenden vertikalen Hohlleiterwänden. Beispielsweise beträgt die Schlitzbreite ungefähr 1,4 mm. Die Schlitzlänge beträgt bevorzugt etwa ein Zehntel bis ein Zwanzigstel der Schlitzbreite, beispielsweise 0,1 mm. Insbesondere lässt sich durch geeignete Wahl der Schlitzlänge eine vorteilhafte Filterwirkung für das durch den Kopplungsschlitz übertragene Signal erzielen. Dabei ermöglicht eine größere Schlitzlänge eine Übertragung einer größeren Frequenzbandbreite, das heißt die Filterwirkung ist verringert. In einer alternativen Ausgestaltung ist die Öffnung als Durchkontaktierung, insbesondere als sogenanntes Via ausgeführt. Dieses erstreckt sich dabei insbesondere wenigstens über diejenigen Substratschichten, in denen der Hohlleiter angeordnet ist.

In einer weiteren bevorzugten Ausgestaltung sind die erste Lage, die erste Masselage und die zweite Lage mittels einer Anzahl von Durchkontaktierungen verbunden. Diese sind beispielweise als Vias ausgeführt, das heißt insbesondere als innenwändig metallisierte Bohrungen. Alternativ sind die Durchkontaktierungen als metallisierte Gräben (sogenannte grooves) ausgeführt. Auf diese Weise sind mehrere Lagen miteinander elektrisch leitend verbindbar und weisen entsprechend ein gemeinsames elektrisches Potential auf. Dadurch ist es insbesondere möglich, die horizontalen Hohlleiterwände auf ein gemeinsames elektrisches Potential, insbesondere Massepotential zu bringen.

Zweckmäßigerweise bilden die Durchkontaktierungen eine Hohlleiterwand, vorzugsweise alle vertikalen Hohlleiterwände des Hohlleiters. Hierdurch ist insbesondere ein geeigneter Hohlleiter geschaffen, dessen Wände vorteilhaft elektrisch leitend miteinander verbunden sind. Im Falle von mit der ersten Massefläche verbundenen Durchkontaktierungen ist der erste Abschnitt weiterhin vorteilhafterweise kurzgeschlossen, wodurch sich ein verbessertes Reflektionsverhalten, im Sinne von einer verringerten Reflektion ergibt.

In einer vorteilhaften Ausführungsform sind die Durchkontaktierungen U-förmig angeordnet mit zwei seitlichen Schenkeln und einem diese verbindenden mittleren Schenkel. Diese Schenkel bilden insbesondere die vertikalen Wände des Hohlleiters. Jeder der beiden Abschnitte weist dann ein offenes Ende auf an dem entsprechend die Signalleitung beziehungsweise die Abschlussleitung anschließbar sind. Desweiteren weist jeder der Abschnitte ein geschlossenes Ende auf, das insbesondere durch den mittleren Schenkel gebildet ist. Vorzugsweise ist die Öffnung in einem geeigneten und insbesondere abhängig von der Frequenz des Signals gewählten Abstand von dem mittleren Schenkel angeordnet. Das Signal liegt in dem Hohlleiter insbesondere als Stehwelle mit einer von der Frequenz abhängigen Wellenlänge vor. Daher ist der Kopplungsschlitz vorteilhafterweise an einem Maximum der Stehwelle angeordnet. Zweckmäßigerweise beträgt der Abstand somit etwa die Hälfte der Wellenlänge oder zusätzlich dazu ein ganzzahliges Vielfaches der halben Wellenlänge. Dadurch ist das Signal besonderes reflexionsarm von dem ersten in den zweiten Abschnitt übertragbar.

Insbesondere sind der erste und der zweite Abschnitt des Hohlleiters übereinander angeordnet, das heißt, die von den Abschnitten jeweils umfassten Bereiche der beiden Substratschichten liegen im Mehrschichtaufbau der Platine übereinander. Hierdurch ist eine besonders platzsparende Ausführung des Hohlleiters möglich. Insbesondere bildet ein Teil der ersten Masselage zwischen den beiden Bereichen sowohl eine horizontale Hohlleiterwand des ersten wie auch des zweiten Abschnittes. In diesem Teil der Masselage ist vorzugsweise die Öffnung zur Übertragung des Signals von dem ersten zu dem zweiten Abschnitt eingebracht.

Jede der Durchkontaktierungen weist vorzugsweise einen oberen, das heißt in der ersten Substratschicht angeordneten Teil auf und einen unteren in der zweiten Substratschicht angeordneten Teil. Die oberen Teile bilden dann insbesondere die vertikalen Hohlleiterwände des ersten Abschnittes; die unteren Teile bilden die vertikalen Hohlleiterwände des zweiten Abschnittes. Der Hohlleiter folgt dann insbesondere einem U-förmigen Verlauf, der jedoch nicht gleich dem U-förmigen Verlauf der Durchkontaktierungen ist.

In einer vorteilhaften Ausgestaltung ist die Abschlussleitung mäanderförmig oder spiralförmig ausgebildet. Je länger die Abschlussleitung ist, desto stärker ist insbesondere die Abschwächung des darin geführten Signales. Durch eine mäanderförmige oder spiralförmige Ausgestaltung ist es dann vorteilhaft möglich, eine möglichst lange Abschlussleitung besonders platzsparend auszuführen, insbesondere in der zweiten Lage anzuordnen.

Vorzugsweise weist die Abschlussleitung ein Leitungsende auf, an dem eine Durchkontaktierung angeordnet ist. Diese ist beispielsweise als Via ausgeführt. Dadurch ist vorteilhafterweise ein Kurzschluss am Leitungsende erzielt, wodurch ein Abstrahlen eines eventuell am Leitungsende vorliegenden Signalrestes vorteilhaft reduziert oder gänzlich unterbunden ist.

In einer bevorzugten Ausführungsform ist die Abschlussleitung als Streifenleiter, sogenannte stripline ausgebildet. Im Vergleich zu beispielsweise einem Mikrostreifenleiter ist ein Streifenleiter typischerweise in einem von zwei Masselagen gebildeten Zwischenraum angeordnet und weist daher eine verbesserte Abschirmung auf. Einem Mikrostreifenleiter ist dagegen üblicherweise lediglich eine Masselage zugeordnet. Das heißt eine Abstrahlung des von dem Streifenleiter geführten Signals ist reduziert oder gänzlich unterbunden. Dadurch ist insbesondere eine Störung weiterer auf der Platine angeordneter Bauelemente vermeidbar.

Bevorzugterweise ist die Abschlussleitung zwischen der zweiten und einer dritten Substratschicht angeordnet. Dadurch erfährt ein mittels der Abschlussleitung geführtes Signal eine besonders hohe Absorption und die Wirkung des Wellenabschlusses ist entsprechend verbessert. Vorzugsweise sind die zweite und die dritte Substratschicht aus dem gleichen Material gefertigt sind. Dadurch ist der Fertigungsaufwand der Platine entsprechend reduziert.

In einer zweckmäßigen Weiterbildung ist auf einer der zweiten Lage gegenüberliegenden Seite der dritten Substratschicht eine zweite Masselage angeordnet. In Kombination mit der ersten Masselage ist es insbesondere möglich, die Abschlussleitung auf einfache Weise als Streifenleiter auszubilden. Die Abschlussleitung ist dann der Streifenleiter und die die beiden Masselagen bilden eine entsprechende Begrenzung in vertikaler Richtung. Dabei ist die zweite Lage, welche die Abschlussleitung umfasst, von der zweiten und der dritten Substratschicht eingefasst und die beiden Substratschichten sind wiederum von den beiden Masseflächen eingefasst.

In einer bevorzugten Ausführungsform ist die Platine als Mehrschichtsystem oder auch Mehrlagenplatine als Stapel mit einer in vertikaler Richtung zeigenden Stapelrichtung wie folgt zusammengesetzt: erste Lage, erste Substratschicht, erste Masselage, zweite Substratschicht, zweite Lage, dritte Substratschicht, zweite Masselage. Dabei ist es möglich, dass eine oder mehrere Lagen, insbesondere die erste Lage und die zweite Massefläche zusätzlich eine auf diese aufgebrachte Lackschicht oder andere Schutzschicht aufweisen. Diese ist dann insbesondere aus einem isolierenden Material gefertigt.

Nachfolgend wird ein Ausführungsbeispiel der Erfindung anhand einer Zeichnung näher erläutert. Darin zeigen:
- Fig. 1: schematisch und in Schnittdarstellung ein Radarsystem mit einer als Mehrlagenplatine ausgebildeten Platine,
- Fig. 2: schematisch in einer perspektivischen Darstellung einen Ausschnitt der Platine gemäß Fig. 1 mit einem Wellenabschluss,
- Fig. 3: in Draufsicht den Ausschnitt gemäß Fig. 2 und eine erste Lage,
- Fig. 4: in Draufsicht eine erste Masselage des Ausschnitt gemäß Fig. 2,
- Fig. 5: in Draufsicht eine zweite Lage des Ausschnitt gemäß Fig. 2,
- Fig. 6: in Draufsicht eine zweite Masselage des Ausschnitt gemäß Fig. 2, und
- Fig. 7: ein simuliertes und ein gemessenes Reflexionsverhalten des Wellenabschlusses gemäß Fig. 2.

Die in der folgenden Beschreibung genannten Dimensionierungen und Zahlenangaben sind lediglich als Beispiele zu verstehen.

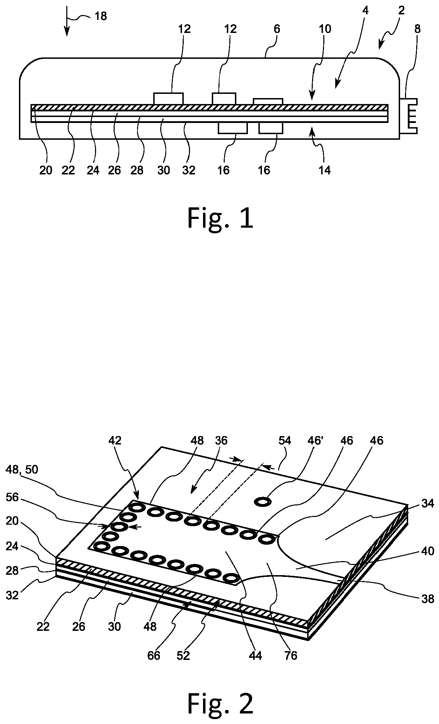

Ein Radarsystem 2 mit einer Platine 4 und einem Gehäuse 6 ist in Fig. 1 gezeigt. Das Radarsystem 2 ist insbesondere zur Verwendung in einem hier nicht dargestellten Fahrzeug geeignet, beispielsweise als Abstandswarnvorrichtung, und umfasst insbesondere hier nicht weiter dargestellte geeignete Sende- und Empfangsvorrichtungen, beispielsweise Antennen. Das Gehäuse 6 weist zusätzlich einen Anschluss 8 auf, über den das Radarsystem 2 beispielsweise mit weiteren hier nicht dargestellten Systemen zwecks Datenaustausch verbunden ist. Insbesondere ist das Radarsystem mit einem Steuerungs- und/oder Datenverarbeitungssystem des Fahrzeuges verbunden. Alternativ oder zusätzlich weist das Radarsystem 2 insbesondere eine ebenfalls nicht näher dargestellte Steuerungseinrichtung auf, beispielsweise zur Auswertung von Daten oder einer Steuerung des Radarsystems 2.

Die Platine 4 umfasst eine Oberseite 10, auf der eine Anzahl von HF-Bauteilen 12 angeordnet ist, sowie eine Unterseite 14, auf der zusätzliche elektronische Bauteile 16 angeordnet sind. Insbesondere ist die Platine 4 ein Mehrschichtsystem und umfasst mehrere Lagen und Substratschichten, die einen Stapel bilden. Die in Fig. 1 dargestellte Platine 4 umfasst in Stapelrichtung 18, das heißt beginnend auf der Oberseite 10 und in Richtung der Unterseite 14 (oder auch von oben nach unten) folgende Lagen und Substratschichten: eine erste Lage 20, eine erste Substratschicht 22 (hier schraffiert dargestellt), eine erste Masselage 24, eine zweite Substratschicht 26, eine zweite Lage 28, eine dritte Substratschicht 30 und eine zweite Masselage 32.

Ein Ausschnitt der Platine 4 gemäß Fig. 1 ist in Fig. 2 dargestellt. In beiden Figuren deutlich erkennbar ist der mehrschichtige Aufbau der Platine 4. Die Lagen 20, 24, 28, 32 sind jeweils aus einem leitenden Material (beispielsweise Kupfer) gefertigt. Dabei können Teile der jeweiligen Lage 20, 24, 28, 32 ausgelassen sein, das heißt, eine Lage 20, 24, 28, 32 kann auch Bereiche 34 aufweisen, in denen kein leitendes Material aufgebracht ist. Beispielsweise sind die beiden Masselagen 24, 32 auf dem gezeigten Abschnitt im Wesentlichen vollständig als Flächen aus leitendem Material ausgeführt; die beiden Lagen 20, 28 weisen jedoch freie Bereiche auf zur Ausbildung von Leiterstrukturen aus leitendem Material. Letzteres ist besonders deutlich für die erste Lage 20 erkennbar, die hier eine Außenlage oder Top-Lage bildet. Ebenso umfasst die zweite Lage 28 freie Bereiche; in Fig. 2 ist dies durch unterschiedliche Linienstärken der zweiten Lage angedeutet.

In dem hier gezeigten Ausführungsbeispiel ist die erste Substratschicht 22 aus einem HF-Material gefertigt, beispielsweise aus dem unter dem Markennamen RO3003 bekannten Material; die zweite und dritte Substratschicht 26, 30 sind jeweils aus einem herkömmlichen und insbesondere beide aus einem gleichen Material gefertigt, beispielsweise aus dem unter dem Materialkennzeichen FR4 bekannten Material. Die Materialien sind üblicherweise dielektrisch und weisen jeweils einen Verlustfaktor auf, der ein Maß für das Absorptionsverhalten des jeweiligen Materials darstellt. Dabei zeichnet sich das HF-Material durch einen gegenüber dem herkömmlichen Material geringeren Verlustfaktor aus, insbesondere für elektromagnetische Signale hoher Frequenz, beispielsweise aus einem Frequenzbereich zwischen 10 GHz und 100 GHz. Mit anderen Worten: in dem hier gezeigten Ausführungsbeispiel ist die erste Substratschicht 22 verlustarm, die beiden übrigen Substratschichten 26, 30 sind verlustreich. Die auf der ersten Substratschicht 22 aufgebrachte erste Lage 20 dient daher vorzugsweise zur Führung oder Übermittlung von hochfrequenten Signalen.

In Fig. 2 ist ein Wellenabschluss 36 dargestellt, der an eine Signalleitung 38 angeschlossen ist. Diese ist in Fig. 2 lediglich teilweise sichtbar und verläuft außerhalb des gezeigten Abschnittes weiter. In dem hier gezeigten Ausführungsbeispiel ist die Signalleitung 38 als Mikrostreifenleiter ausgebildet. Dieser dient insbesondere zur Übertragung eines Signals mit einer vorgegebenen Frequenz. Das Signal ist insbesondere hochfrequent, beispielsweise ist die Frequenz aus einem Frequenzbereich von 10 GHz bis 100GHz ausgewählt und beträgt beispielsweise etwa 77 GHz.

Die Signalleitung 38 ist mittels eines hier trichterförmigen Übergangsbereiches 40 an einen Hohlleiter 42 angeschlossen, der ein Teil des Wellenabschlusses 36 ist. Dabei zeigt Fig. 2 lediglich eine horizontale Hohlleiterwand 44 des Hohlleiters 42. Diese Hohlleiterwand 44, der Übergangsbereich 40 und die Signalleitung 38 sind aus einem leitenden Material gefertigt und als Teil der ersten Lage 20 auf die erste Substratschicht 22 aufgebracht. Zusätzlich ist die erste Lage 20 üblicherweise mit einem hier nicht gezeigten Schutzlack überzogen.

Weiterhin erkennbar ist eine Anzahl von Durchkontaktierungen 46, die insbesondere U-förmig angeordnet sind und auf diese Weise zwei seitliche Schenkel und einen diese verbindenden mittleren Schenkel bilden. Die Durchkontaktierungen 46 erstrecken sich in Stapelrichtung 18, wodurch die seitlichen Schenkel jeweils eine vertikale Hohlleiterwand 48 des Hohlleiters 42 bilden; der mittlere Schenkel bildet insbesondere ein geschlossenes Ende 50 eines ersten Abschnittes 52 des Hohlleiters 42.

Die Durchkontaktierungen 46 sind in einem vorgegebenen Abstand 54 zueinander beabstandet und weisen einen vorgegebenen Durchmesser 56 auf. Der Abstand 54 und der Durchmesser 56 sind insbesondere in Abhängigkeit der Frequenz des Signals geeignet ausgewählt. Beispielsweise beträgt der Abstand 54 etwa 0,5 mm und der Durchmesser 56 etwa 0,3 mm.

Zusätzlich ist eine weitere Durchkontaktierung 46' abseits von den Durchkontaktierungen 46 angeordnet. Diese ist insbesondere nach gleicher Art wie die Durchkontaktierungen 46 ausgebildet. In dem hier gezeigten Ausführungsbeispiel sind die Durchkontaktierungen 46, 46' als sogenannte Vias, das heißt als innenwändig metallisierte Löcher, insbesondere Bohrungen ausgeführt und erstrecken sich über alle vier Lagen 20, 24, 28, 32 und durch alle drei Substratschichten 22, 26, 30. Alternativ sind die Löcher nicht nur innenwändig metallisiert sondern komplett mit leitendem Material ausgefüllt, beispielsweise ist ein geeigneter Stift in das Loch eingesetzt.

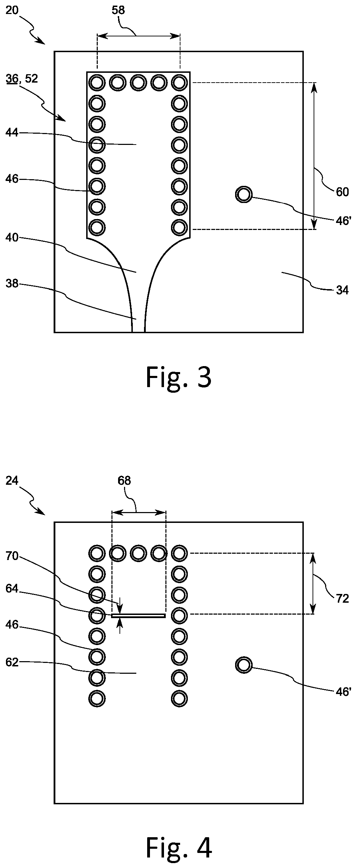

Die Fig. 3 bis 6 zeigen jeweils eine der vier Lagen 20, 24, 28, 32 in Draufsicht. Dabei erstreckt sich der Wellenabschluss 36 über mehrere der Lagen 20, 24, 28, 32 und Substratschichten 22, 26, 30 der Platine. Die erste Lage 20 ist in Fig. 3 dargestellt. Deutlich erkennbar sind die U-förmig angeordneten Durchkontaktierungen 46 zur Ausbildung des Hohlleiters 42 und der Übergangsbereich 40, der die Signalleitung 38 mit dem Hohlleiter 42 verbindet.

Der Hohlleiter 42 weist dabei eine Breite 58 und eine Länge 60 auf, die insbesondere durch die Anordnung der Durchkontaktierungen 46 vorgegeben ist. Geeigneterweise ist diese Anordnung und somit die Breite 58 und die Länge 60 des Hohlleiters 42 abhängig von der Frequenz des Signals ausgewählt. Beispielsweise beträgt die Breite 58 etwa 2 mm und die Länge 60 etwa 3,5 mm.

Fig. 4 zeigt die in Stapelrichtung 18 auf die erste Substratschicht 22 folgende erste Masselage 24, die insbesondere im Bereich der U-förmig angeordneten Durchkontaktierungen 46 eine horizontale Hohlleiterwand 62 umfasst. Diese Hohlleiterwand 62 in Kombination mit der in der ersten Lage 20 ausgebildeten Hohlleiterwand 44 und den Durchkontaktierungen 46 schließen einen Raumbereich in der ersten Substratschicht 22 ein und bilden somit den ersten Abschnitt 52 des Hohlleiters 42. Insbesondere durch die U-förmige Anordnung der Durchkontaktierungen 46 und die Verbindung mit der ersten Masselage 24 ist dieser Abschnitt 52 kurzgeschlossen.

Die erste Masselage 24 ist in dem gezeigten Ausschnitt im Wesentlichen komplett aus leitendem Material gefertigt; ausgenommen sind lediglich die Durchkontaktierungen 46 und eine als Kopplungsschlitz 64 ausgebildete Öffnung. Dieser Kopplungsschlitz 64 ist in die horizontale Hohlleiterwand 62 eingebracht und ermöglicht insbesondere eine Kopplung des ersten Abschnittes 52, mit einem darunter angeordneten zweiten Abschnitt 66 des Hohlleiters 42. Mit anderen Worten: das von der Signalleitung 38 aus in den ersten Abschnitt 52 des Hohlleiters 42 eingekoppelte Signal ist mittels des Kopplungsschlitzes 64 weiter in den zweiten Abschnitt 66 übertragbar. Dieser ist im Wesentlichen in der zweiten Substratschicht 26 angeordnet.

Der Kopplungsschlitz 64 ist derart ausgeführt, dass das Signal möglichst reflexionsfrei vom ersten Abschnitt 52 in den zweiten Abschnitt 66 überführbar ist. In der in Fig. 4 gezeigten Ausführungsform ist der Kopplungsschlitz 64 rechteckig ausgebildet, mit einer Schlitzbreite 68, die geringer als die Breite 58 des Hohlleiters 42 ist, und mit einer Schlitzlänge 70, die etwa eine Größenordnung geringer ist, als die Schlitzbreite 68. Geeigneterweise sind die Schlitzbreite 68 und/oder die Schlitzlänge 70 in Abhängigkeit der Frequenz ausgewählt. Beispielsweise beträgt die Schlitzbreite 68 1,4 mm und die Schlitzlänge 70 0,1 mm. Weiterhin ist der Kopplungsschlitz 64 in einem bestimmten Abstand 72 von dem geschlossenen Ende 50 des Hohlleiters 42 angeordnet und beträgt beispielsweise 1,5 mm, das heißt insbesondere etwa die Hälfte der Wellenlänge eines Signals mit einer Frequenz von etwa 77 GHz.

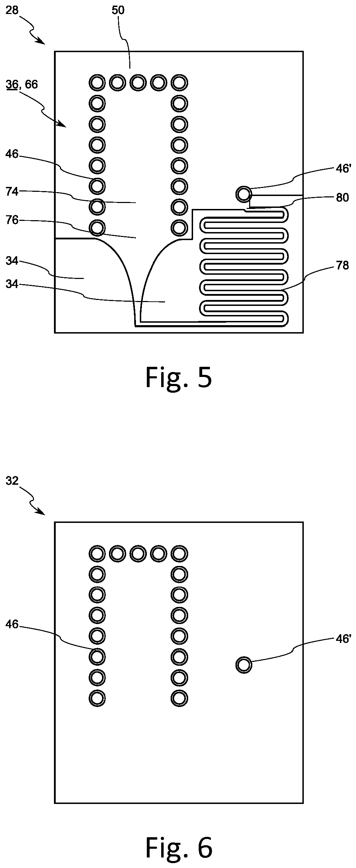

Fig. 5 zeigt die zweite Lage 28, die in Stapelrichtung 18 unter der zweiten Substratschicht 26 angeordnet ist. Die U-förmig angeordneten Durchkontaktierungen 46 schließen einen Teil der zweiten Lage 28 ein, der auf diese Weise eine horizontale Hohlleiterwand 74 des Hohlleiters, insbesondere des zweiten Abschnittes 66 bildet. Dieser ist folglich mittels der in der zweiten Lage 28 und der ersten Masselage 24 angeordneten horizontalen Hohlleiterwände 62, 74 und der Durchkontaktierungen 46 gebildet. In dem hier gezeigten Ausführungsbeispiel bilden die Durchkontaktierungen 46 demnach gleichzeitig vertikale Hohlleiterwände 48 des ersten und des zweiten Abschnittes 52, 66. Ein derart ausgebildeter Hohlleiter 42 ist aufgrund der in Stapelrichtung 18 übereinander angeordneten Abschnitte 52, 66 besonderes platzsparend ausgeführt. Dabei dient die in der ersten Masselage 24 ausgebildete horizontale Hohlleiterwand 62 sowohl als untere Hohlleiterwand des ersten Abschnittes 52 als auch als obere Hohlleiterwand des zweiten Abschnittes 66.

In einer alternativen, hier nicht gezeigten Ausführungsform sind die beiden Abschnitte 52, 66 nicht übereinander angeordnet. Insbesondere sind dann möglicherweise weitere Durchkontaktierungen 46 nötig, um entsprechend geeignete vertikale Hohlleiterwände 48 auszubilden. Jedoch überlappen der erste und der zweite Abschnitt 52, 66 vorzugsweise wenigstens teilweise in Stapelrichtung 18 und zwar derart, dass diese mittels des Kopplungsschlitzes 64 zur Übertragung des Signals verbunden sind.

Da die Durchkontaktierungen 46 in dem hier gezeigten Ausführungsbeispiel vertikale Hohlleiterwände 48 des zweiten Abschnittes 66 bilden, ist dieser somit im Wesentlichen bezüglich der ersten Massefläche 24 spiegelsymmetrisch zum ersten Abschnitt 52 ausgebildet.

Der zweite Abschnitt 66 weist bedingt durch die U-förmige Anordnung der Durchkontaktierungen 46 ein offenes Ende 76 auf. Dieses ist mittels eines weiteren Übergangsbereiches 40 mit einer Abschlussleitung 78 verbunden, die hier als Streifenleiter, sogenannte stripline ausgeführt ist. Da die Abschlussleitung 78 von der zweiten und der dritten Substratschicht 26, 30 umgeben ist, die beide jeweils aus einem Material mit hohem Verlustfaktor gefertigt sind, erfährt das Signal bei Übertragung durch die Abschlussleitung 78 entsprechend große Verluste. Dabei sind die Verluste umso größer, je länger die Abschlussleitung 78 ist. Zur Realisierung einer möglichst langen Abschlussleitung 78 bei gleichzeitig geringem Platzbedarf, verläuft diese in der in Fig. 5 gezeigten Variante im Wesentlichen mäanderförmig. In einer hier nicht gezeigten Variante verläuft die Abschlussleitung 78 jedoch beispielsweise spiralförmig.

Die Abschlussleitung 78 weist ein Leitungsende 80 auf, an dem die Durchkontaktierung 46' angeordnet ist. Diese verbindet einerseits das Leitungsende 80 auf insbesondere kurzem Wege mit den beiden Masselagen 24, 32 und bietet andererseits einen Zugang zur Abschlussleitung 78 zwecks einer Transmissionsmessung, um die Absorptionswirkung des Wellenabschlusses 42 zu ermitteln.

Fig. 6 zeigt die zweite Masselage 32, die in dem gezeigten Ausschnitt bis auf die Durchkontaktierungen 46, 46' vollständig als Fläche aus leitendem Material ausgebildet ist. Insbesondere weist die zweite Masselage 32 wie auch die erste Masselage 24 im Bereich unter- beziehungsweise oberhalb der Abschlussleitung 78 durchgängig leitendes Material auf, wodurch die Abschlussleitung 78 insbesondere als Streifenleiter (das heißt stripline) ausgebildet ist.

Die Durchkontaktierungen 46, 46' sind in dem hier gezeigten Ausführungsbeispiel durchgängig ausgeführt, das heißt, diese verbinden alle vier Lagen 20, 24, 28, 32 miteinander. Insbesondere sind in dem hier gezeigten Ausschnitt der Platine 4 die jeweils mit leitendem Material versehenen Bereiche der vier Lagen 20, 24, 28, 32 miteinander elektrisch leitend verbunden und insbesondere mit einem Massepotential kurzgeschlossen.

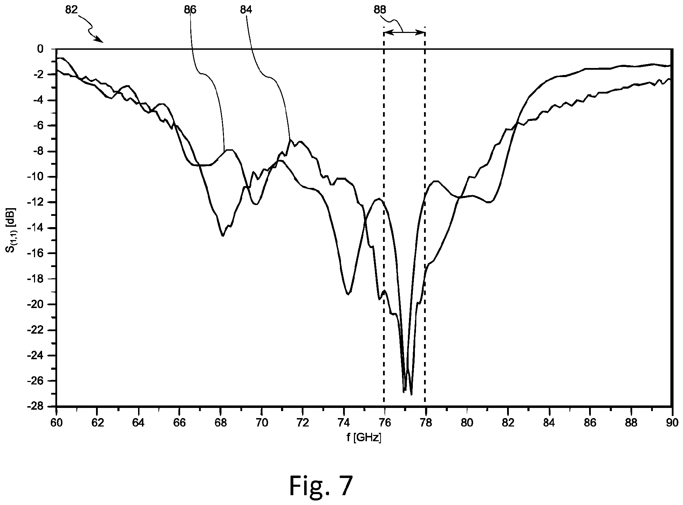

Fig. 7 zeigt einen Graphen 82 mit zwei Kurven 84, 86 zur Verdeutlichung der Funktionalität des Wellenabschlusses 36. Mit Funktionalität ist dabei insbesondere eine reflexionsarme Aufnahme oder Absorption eines hochfrequenten Signals gemeint. Bei Einspeisung eines Eingangssignals in den Wellenabschluss 36 wird ein bestimmter Teil reflektiert und liegt entsprechend als Ausgangssignal vor. Zur Ermittlung einer mittels des Wellenabschlusses 36 erzielten Abschwächung werden jeweils Signalstärken von Eingangs- und Ausgangssignal gemessen. Das Verhältnis von der Signalstärke des Ausgangssignals zur Signalstärke des Eingangssignals entspricht dann einem Reflexionsparameter, insbesondere einem sogenannten S-Parameter (S_{1,1}). In dem Graphen 82 ist der Reflexionsparameter S_{1,1} in Dezibel als Funktion der Frequenz f des Eingangssignals in Gigahertz aufgetragen. Entlang der Ordinate des Graphen 82 ist der Reflexionsparameter S_{1,1} aufgetragen und entlang der Abszisse die Frequenz f.

Die Kurve 84 zeigt dabei ein Messergebnis, die Kurve 86 zeigt ein Simulationsergebnis. Deutlich erkennbar ist in beiden Fällen eine Abschwächung in einem Zielbereich 88 der hier einen Frequenzbereich von 76 GHz bis 78 GHz umfasst. Der hier vermessene beziehungsweise simulierte Wellenabschluss 36 ist bei einer Frequenz von etwa 77 GHz besonders reflexionsarm. Insbesondere zeigen beide Kurven 84, 86 einen ähnlichen Verlauf. Der hier verwendete Wellenabschluss 36 eignet sich also insbesondere zum Betrieb bei einer Frequenz nahe 77 GHz. Durch entsprechend geeignete Änderungen der diversen Dimensionierungen des Wellenabschlusses 36 ist es vorteilhafterweise möglich, ein zumindest ähnliches Verhalten bei anderen Frequenzen zu erzielen.

### Bezugszeichenliste

- 2: Radarsystem
- 4: Platine
- 6: Gehäuse
- 8: Anschluss
- 10: Oberseite (der Platine)
- 12: HF-Bauteil
- 14: Unterseite (der Platine)
- 16: Bauteil
- 18: Stapelrichtung
- 20: erste Lage
- 22: erste Substratschicht
- 24: erste Masselage
- 26: zweite Substratschicht
- 28: zweite Lage
- 30: dritte Substratschicht
- 32: zweite Masselage
- 34: freier Bereich
- 36: Wellenabschluss
- 38: Signalleitung
- 40: Übergangsbereich
- 42: Hohlleiter
- 44: Hohlleiterwand (horizontal, in der ersten Lage)
- 46: Durchkontaktierung
- 46': Durchkontaktierung
- 48: Hohlleiterwand (vertikal)
- 50: geschlossenes Ende
- 52: erster Abschnitt (des Hohlleiters)
- 54: Abstand (zweier Durchkontaktierungen)
- 56: Durchmesser (der Durchkontaktierung)
- 58: Breite (des Hohlleiters)
- 60: Länge (des Hohlleiters)
- 62: Hohlleiterwand (horizontal, in der ersten Masselage)
- 64: Kopplungsschlitz
- 66: zweiter Abschnitt (des Hohlleiters)
- 68: Schlitzbreite
- 70: Schlitzlänge
- 72: Abstand (Kopplungsschlitz zu geschlossenem Ende)
- 74: Hohlleiterwand (horizontal, zweite Lage)
- 76: offenes Ende
- 78: Abschlussleitung
- 80: Leitungsende
- 82: Graph
- 84: Kurve (Messergebnis)
- 86: Kurve (Simulationsergebnis)
- 88: Zielbereich

## Patentansprüche

1. Platine (4), für ein Radarsystem (2), umfassend
- einen Wellenabschluss (36) mit einer Abschlussleitung (78),
- eine mit dieser verbundene Signalleitung (38) zur Übertragung eines hochfrequenten Signals,
- eine erste Substratschicht (22), die aus einem ersten Material mit einem ersten Verlustfaktor gefertigt ist,
- eine auf der ersten Substratschicht (22) aufgebrachte erste Lage (20), welche die Signalleitung (38) umfasst,
- eine zweite Substratschicht (26), die aus einem zweiten Material mit einem zweiten Verlustfaktor gefertigt ist,
- eine auf der zweiten Substratschicht (26) aufgebrachte zweite Lage (28), die die Abschlussleitung (78) umfasst, wobei der zweite Verlustfaktor größer ist als der erste Verlustfaktor, derart, dass in dem Wellenabschluss eine Abschwächung, Dämpfung oder Absorption des Signals dadurch erzielt wird, dass dieser das Signal von der vergleichsweise verlustarmen ersten Lage in die vergleichsweise verlustreiche zweite Lage führt oder leitet.

2. Platine (4) nach Anspruch 1,
**dadurch gekennzeichnet,**
**dass** die Abschlussleitung (78) und die Signalleitung (38) mittels eines Hohlleiters (42) verbunden sind.

3. Platine (4) nach Anspruch 2,
**dadurch gekennzeichnet,**
**dass** der Hohlleiter (42) einen ersten Abschnitt (52) aufweist, der in der ersten Substratschicht (22) angeordnet ist und einen zweiten Abschnitt (66), der in der zweiten Substratschicht (26) angeordnet ist.

4. Platine (4) nach einem der vorhergehenden Ansprüche,
**dadurch gekennzeichnet,**
**dass** zwischen der ersten und der zweiten Substratschicht (22, 26) eine erste Masselage (24) angeordnet ist.

5. Platine (4) nach Anspruch 4,
**dadurch gekennzeichnet,**
**dass** in die erste Masselage (24) ein Kopplungsschlitz (64) eingebracht ist.

6. Platine (4) nach Anspruch 4 oder 5,
**dadurch gekennzeichnet,**
**dass** die erste Lage (20), die zweite Lage (28) und die erste Masselage (24) mittels einer Anzahl von Durchkontaktierungen (46) verbunden sind.

7. Platine (4) nach Anspruch 6,
**dadurch gekennzeichnet,**
**dass** die Durchkontaktierungen (46) eine Hohlleiterwand (48) des Hohlleiters (42) bilden.

8. Platine (4) nach Anspruch 6 oder 7,
**dadurch gekennzeichnet,**
**dass** die Durchkontaktierungen (46) U-förmig angeordnet sind.

9. Platine (4) nach einem der vorhergehenden Ansprüche,
**dadurch gekennzeichnet,**
**dass** die Abschlussleitung (78) mäanderförmig ausgebildet ist.

10. Platine (4) nach einem der vorhergehenden Ansprüche,
**dadurch gekennzeichnet,**
**dass** die Abschlussleitung (78) ein Leitungsende (80) aufweist, an dem eine Durchkontaktierung (46') angeordnet ist.

11. Platine (4) nach einem der vorhergehenden Ansprüche,
**dadurch gekennzeichnet,**
**dass** die Abschlussleitung (78) als Streifenleiter ausgebildet ist.

12. Platine (4) nach einem der vorhergehenden Ansprüche,
**dadurch gekennzeichnet,**
**dass** die Abschlussleitung (78) zwischen der zweiten und einer dritten Substratschicht (26, 30) angeordnet ist.

13. Platine (4) nach Anspruch 12,
**dadurch gekennzeichnet,**
**dass** die zweite und die dritte Substratschicht (26, 30) aus dem gleichen Material gefertigt sind.

14. Platine (4) nach Anspruch 12 oder 13,
**dadurch gekennzeichnet,**
**dass** auf einer der zweiten Lage (28) gegenüberliegenden Seite der dritten Substratschicht (30) eine zweite Masselage (32) angeordnet ist.

15. Radarsystem (2) zur Umfelderfassung für ein Fahrzeug umfassend eine Platine (4) gemäß einer der vorherigen Ansprüche.

## Claims

1. Printed circuit board (4) for a radar system (2), comprising
- a wave termination (36) with a termination line (78),
- a signal line (38), connected to said termination line, for transmitting a high-frequency signal,
- a first substrate lamination (22), which is manufactured from a first material with a first loss factor,
- a first layer (20), which is applied to the first substrate lamination (22) and comprises the signal line (38),
- a second substrate lamination (26), which is manufactured from a second material with a second loss factor,
- a second layer (28), which is applied to the second substrate lamination (26) and comprises the termination line (78),
wherein the second loss factor is greater than the first loss factor, such that attenuation, damping or absorption of the signal is achieved in the wave termination in that said wave termination guides or conducts the signal from the comparatively low-loss first layer into the comparatively high-loss second layer.

2. Printed circuit board (4) according to Claim 1,
**characterized in that**
the termination line (78) and the signal line (38) are connected by means of a waveguide (42).

3. Printed circuit board (4) according to Claim 2,
**characterized in that**
the waveguide (42) has a first portion (52), which is arranged in the first substrate lamination (22), and a second portion (66), which is arranged in the second substrate lamination (26).

4. Printed circuit board (4) according to one of the preceding claims,
**characterized in that**
a first ground layer (24) is arranged between the first and the second substrate lamination (22, 26).

5. Printed circuit board (4) according to Claim 4,
**characterized in that**
a coupling slit (64) is introduced in the first ground layer (24).

6. Printed circuit board (4) according to Claim 4 or 5,
**characterized in that**
the first layer (20), the second layer (28) and the first ground layer (24) are connected by means of a number of plated through-holes (46).

7. Printed circuit board (4) according to Claim 6,
**characterized in that**
the plated through-holes (46) form a waveguide wall (48) of the waveguide (42).

8. Printed circuit board (4) according to Claim 6 or 7,
**characterized in that**
the plated through-holes (46) are arranged in a U shape.

9. Printed circuit board (4) according to one of the preceding claims,
**characterized in that**
the termination line (78) has a meandering form.

10. Printed circuit board (4) according to one of the preceding claims,
**characterized in that**
the termination line (78) has a line end (80), at which a plated through-hole (46') is arranged.

11. Printed circuit board (4) according to one of the preceding claims,
**characterized in that**
the termination line (78) is in the form of a strip line.

12. Printed circuit board (4) according to one of the preceding claims,
**characterized in that**
the termination line (78) is arranged between the second and a third substrate lamination (26, 30).

13. Printed circuit board (4) according to Claim 12,
**characterized in that**
the second and the third substrate lamination (26, 30) are manufactured from the same material.

14. Printed circuit board (4) according to Claim 12 or 13,
**characterized in that**
a second ground layer (32) is arranged on a side, situated opposite the second layer (28), of the third substrate lamination (30).

15. Radar system (2) for detecting the surroundings of a vehicle, comprising a printed circuit board (4) according to one of the preceding claims.

## Revendications

1. Carte de circuit (4), destinée à un système radar (2), comprenant
- une terminaison d'onde (36) pourvue d'une ligne de terminaison (78),
- une ligne de signal (38) raccordée à celle-ci et destinée à transmettre un signal à haute fréquence,
- une première couche de substrat (22) constituée d'un premier matériau ayant un premier facteur de perte,
- une première couche (20) déposée sur la première couche de substrat (22) et comprenant la ligne de signal (38),
- une deuxième couche de substrat (26) constituée d'un deuxième matériau ayant un deuxième facteur de perte,
- une deuxième couche (28) déposée sur la deuxième couche de substrat (26) et comprenant la ligne de terminaison (78),
le deuxième facteur de perte étant supérieur au premier facteur de perte, de telle sorte qu'une atténuation, un affaiblissement ou une absorption du signal soit obtenu dans la terminaison d'onde par guidage ou acheminement du signal de la première couche à perte relativement faible vers la deuxième couche à perte relativement élevée.

2. Carte de circuit (4) selon la revendication 1, **caractérisée en ce que** la ligne de terminaison (78) et la ligne de signal (38) sont raccordées au moyen d'un guide d'ondes (42).

3. Carte de circuit (4) selon la revendication 2, **caractérisée en ce que** le guide d'ondes (42) comporte une première partie (52) disposée dans la première couche de substrat (22) et une deuxième partie (66) disposée dans la deuxième couche de substrat (26).

4. Carte de circuit (4) selon l'une des revendications précédentes, **caractérisée en ce qu'**une première couche de masse (24) est disposée entre la première et la deuxième couche de substrat (22, 26).

5. Carte de circuit (4) selon la revendication 4, **caractérisée en ce qu'**une fente de couplage (64) est ménagée dans la première couche de masse (24).

6. Carte de circuit (4) selon la revendication 4 ou 5, **caractérisée en ce que** la première couche (20), la deuxième couche (28) et la première couche de masse (24) sont raccordées au moyen d'une pluralité de contacts traversants (46).

7. Carte de circuit (4) selon la revendication 6, **caractérisée en ce que** les contacts traversants (46) forment une paroi de guide d'ondes (48) du guide d'ondes (42) .

8. Carte de circuit (4) selon la revendication 6 ou 7, **caractérisée en ce que** les contacts traversants (46) sont disposés en forme de U.

9. Carte de circuit (4) selon l'une des revendications précédentes, **caractérisée en ce que** la ligne de terminaison (78) présente une forme de méandre.

10. Carte de circuit (4) selon l'une des revendications précédentes, **caractérisée en ce que** la ligne de terminaison (78) présente une extrémité de ligne (80) sur laquelle est disposé un contact traversant (46').

11. Carte de circuit (4) selon l'une des revendications précédentes, **caractérisée en ce que** la ligne de terminaison (78) est réalisée sous la forme d'une ligne à ruban.

12. Carte de circuit (4) selon l'une des revendications précédentes, **caractérisée en ce que** la ligne de terminaison (78) est disposée entre la deuxième et une troisième couche de substrat (26, 30).

13. Carte de circuit (4) selon la revendication 12, **caractérisée en ce que** les deuxième et troisième couches de substrat (26, 30) sont constituées du même matériau.

14. Carte de circuit (4) selon la revendication 12 ou 13, **caractérisée en ce qu'**une deuxième couche de masse (32) est disposée sur un côté de la troisième couche de substrat (30) qui est opposé à la deuxième couche (28).

15. Système radar (2) servant à détecter l'environnement d'un véhicule, comprenant une carte de circuit (4) selon l'une des revendications précédentes.
